# EUROPEAN PATENT APPLICATION

(11) **EP 4 783 453 A1**
(43) Date of publication of application: **29.07.2026**
(21) Application number: 26151943.3
(22) Date of filing: 15.01.2026
(51) Int. Cl.: H02P 29/024, H02K 3/28

(54) **SHORT-CIRCUIT DETECTION IN BIFILAR ELECTRIC MACHINES BY TORQUE AND VIBRATION ANALYSIS**

(30) Priority: 22.01.2025 GB 202500859
(71) Applicant: Rolls-Royce Deutschland Ltd & Co KG, 15827 Blankenfelde-Mahlow (DE)
(72) Inventor: YIRISAW, Tadele, 15827 Blankenfelde-Mahlow (DE); REEH, Andreas, 15827 Blankenfelde-Mahlow (DE); BIRKMAYER, Wolfram Siegfried, 15827 Blankenfelde-Mahlow (DE)

(57) **Abstract**

An electric machine (2, 2') comprises: a stator (21) having a first winding system (WS1) and a second winding system (WS2), wherein at least one electrical conductor (120) of the first winding system (WS1) and at least one electrical conductor (121) of the second winding system (WS2) are at least partially wound around a common winding axis (A) and alternate in a direction of the winding axis (A); a rotor (20) rotatably mounted with respect to the stator (21); and a monitoring device (14) configured to: receive torque signals indicative of a torque transmitted by the rotor (20) at various points in time and/or to receive vibration signals indicative of a vibration of the rotor (20) at various points in time and/or of a vibration of the stator (21) at various points in time; perform a comparison based on the torque signal and/or the vibration signal and based on at least one threshold; and detect a short circuit between the at least one electrical conductor (120) of the first winding system (WS1) and the at least one electrical conductor (121) of the second winding system (WS2) based on the comparison.

## Description

### TECHNICAL FIELD

The present disclosure relates in particular to an electric machine and to an aircraft having such an electric machine.

### BACKGROUND

Such electric machines include a stator with an electrical winding system. By applying voltages to the winding system, particularly voltages that vary over time, magnetic fields are generated that may cause a rotation of a rotor.

Especially in multiphase rotating field machines, (e.g., having a permanently excited rotor), it is problematic when a winding short circuit occurs inside a tooth winding. In particular in such electric machines, the problem exists that, in the event of a winding short circuit between turns during intended operation, a large electrical current may be induced, which current may result in thermal destruction of the tooth windings. This is particularly relevant not only, but particularly, in aircrafts in which, e.g., permanently excited rotating-field machines are used.

Since the thrust produced by conventional electric machines may be almost unaffected directly after occurrence of such a short circuit, the fault may be detected delayed and only after consequential damages have occurred.

### SUMMARY AND DESCRIPTION

The object of the present disclosure is to provide an improved electric machine. The scope of the present disclosure is defined solely by the appended claims and is not affected to any degree by the statements within this summary. The present embodiments may obviate one or more of the drawbacks or limitations in the related art.

According to one aspect, an electric machine is provided. The electric machine comprises a stator having a first winding system and a second winding system, wherein at least one electrical conductor of the first winding system and at least one electrical conductor of the second winding system are at least partially wound around a common winding axis and alternate in a direction of the winding axis. The electric machine further comprises a rotor rotatably mounted with respect to the stator and a monitoring device. The monitoring device is configured to receive torque signals respectively indicative of a torque transmitted by the rotor at various points in time. Alternatively, or in addition, the monitoring device is configured to receive vibration signals respectively indicative of a vibration of the rotor at various points in time and/or the forces or vibration of stator at different points in time. The monitoring device is further configured to perform a comparison based on (a) the torque signal and/or the vibration signal and based on (b) at least one threshold. The monitoring device is further configured to detect a short circuit between the (at least one) electrical conductor of the first winding system and the (at least one) electrical conductor of the second winding system based on the comparison, e.g., the exceedance of the threshold.

Such an electric machine makes it possible to reliably detect an inter-turn short circuit between adjacent turns of a winding portion, e.g., in order to quickly initiate countermeasures, (e.g., switching off a power supply and/or shutting down the electric machine in safe operation in order to avoid dangerous operating states). This is based on the finding that, unlike in conventional electric machines, in bifilar electric machines a turn-to-turn fault immediately results in torque ripples. When detecting such a change in the torque and/or the resulting vibration signature, a fast and effective detection of such a fault is possible. Thus, an improved electric machine is obtained.

The alternating arrangement of the conductor windings may also be referred to as bifilar arrangement. The electrical conductors of the two winding systems are disposed in a bifilar arrangement. The monitoring device may comprise one or more operatively connected parts that may be located adjacent to one another or displaced with respect to one another. The monitoring device may be a part of an inverter system of the electric machine. Further, the monitoring device may at least partially be embodied as software and/or hardware.

The electric machine may further comprise a torque sensor for measuring a torque resulting from operation of the electric machine by providing an AC current to the first winding system and/or by providing an AC current to the second winding system. The torque sensor may be configured for providing the torque signals being indicative for the measured torque to the monitoring device.

The torque sensor may comprise at least one strain gauge. The at least one strain gauge may be mounted on the rotor or on a shaft driven by the rotor to measure the transmitted torque. This allows a precise and simple measurement of the actual torque.

The electric machine may further comprise a vibration sensor for measuring a vibration resulting from operation of the electric machine. The vibration sensor may be configured for providing the vibration signals being indicative for the measured vibration to the monitoring device. This allows an improved measurement.

The vibration sensor may be mounted on the stator or on a static part fixedly connected to the stator. The vibration sensor may be mounted adjacent to a bearing supporting rotation of the rotor or a rotating part driven by the rotor. By this, a precise measurement of a vibration resulting from an inter-turn short circuit can be provided.

The electric machine may further comprise a control unit configured to operate the stator to drive the rotor with a target torque value and/or a target vibration value. The monitoring device may be configured to receive the target torque/vibration value from the control unit. This allows to normalize the measured torque/vibration to provide a measurement that more prominently reflects fault-induced torque ripples. This may also be provided for the target vibration value, where the vibration value is not used to control the electric machine, but only for fault detection.

The monitoring device may be further configured to perform the comparison by calculating a respective difference and/or a respective ratio between the torque/vibration indicated by the torque and/or vibration signals and the received target torque/vibration value(s). The monitoring device may also be configured to compare the difference and/or the ratio with the at least one threshold. This may also be provided for the target vibration value, where the vibration value is not used to control the electric machine, but only for fault detection.

The monitoring device may be configured to perform the comparison by determining the time derivative of the torque and/or vibration signals (and/or of said difference or ratio) and comparing the time derivative with the at least one threshold. This allows a precise detection of the fault.

The monitoring device may be configured to perform the comparison by directly comparing the torque and/or vibration signals with the at least one threshold. This allows a particularly simple analysis.

The monitoring device may be configured to perform the comparison by bandpass-filtering the torque and/or vibration signal and/or determining a spectral energy contained in the (e.g., bandpass-filtered) torque (and/or vibration) signal and, optionally, comparing the determined spectral energy with the at least one threshold. This allows a particularly precise analysis.

The monitoring device may be configured to detect a short circuit between the first electrical conductor and the second electrical conductor based on the comparison by determining that the at least one threshold is exceeded. In this manner a very quick result can be obtained.

According to an example, the monitoring device is configured to detect a short circuit between the first electrical conductor and the second electrical conductor based on the comparison by determining that the comparison based on the torque signal exceeds a torque threshold and the comparison based on the vibration signal exceeds a vibration threshold. Such a detection is particularly robust against false positives while allowing a fast detection.

In a further example, the monitoring device is configured to trigger a change of operation of the electric machine, e.g., a shut-down, in response to detecting the short circuit. This may prevent consequential damages.

The electric machine may further comprise an inverter system with a first inverter for the first winding system and a second inverter for the second winding system. Herewith, a redundant and fail-safe operation is possible.

The first winding system may comprise three electrical conductors connected with each other at a (first) star point. The second winding system may comprise three electrical conductors connected with each other at a (second) star point. The first inverter may provide one respective phase to each of the three electrical conductors of the first winding system. The second inverter may provide one respective phase to each of the three electrical conductors of the second winding system. This allows an efficient operation of the electric machine.

According to one aspect, a vehicle, (e.g., an aircraft), is disclosed. The vehicle includes the electric machine according to any configuration described herein, in particular for driving a thrust-generating apparatus, e.g. a propeller. The advantages of the electric machine described herein apply especially to a vehicle, in particular an aircraft. However, the assembly may also be used in a gas pump, in a marine engine, in a wind turbine, or in a generator.

### BRIEF DESCRIPTION OF THE DRAWINGS

Embodiments will now be described by way of example with reference to the figures in which:
- FIG. 1: depicts a schematic sectional illustration of an example of a basic design of a permanently excited, three-phase electric machine having an internal rotor.
- FIG. 2: depicts a schematic, perspective exploded view of an example of a design of an arrangement comprising a stator of the electric machine according to FIG. 1 with tooth windings.
- FIG. 3: depicts a schematic illustration of an example of part of a tooth winding of the arrangement according to FIG. 2, in which turns of a first and second electrical conductor are arranged in a bifilar manner.
- FIG. 4: depicts a schematic illustration of an example of a permanently excited electric machine for operation at a three-phase AC voltage.
- FIGS. 5 and 6: depict schematic circuit diagram illustrations of examples of tooth windings and inverter units of an inverter of the electric machine according to FIG. 2 and FIG. 4, respectively.
- FIG. 7: depicts an example of switching signals for the inverter units.
- FIG. 8: depicts a block diagram of an example of components of the inverter.
- FIG. 9: depicts a block diagram of an arrangement for detecting a fault in a bifilar motor.
- FIG. 10: depicts strain gauges to measure a torque.
- FIG. 11: depicts an arrangement of a vibration sensor.
- FIG. 12: depicts a diagram showing torque ripples due to a fault in a bifilar motor.
- FIG. 13: depicts an example of an aircraft in the form of an airplane having an electrically driven propeller and the electric machine.

### DETAILED DESCRIPTION

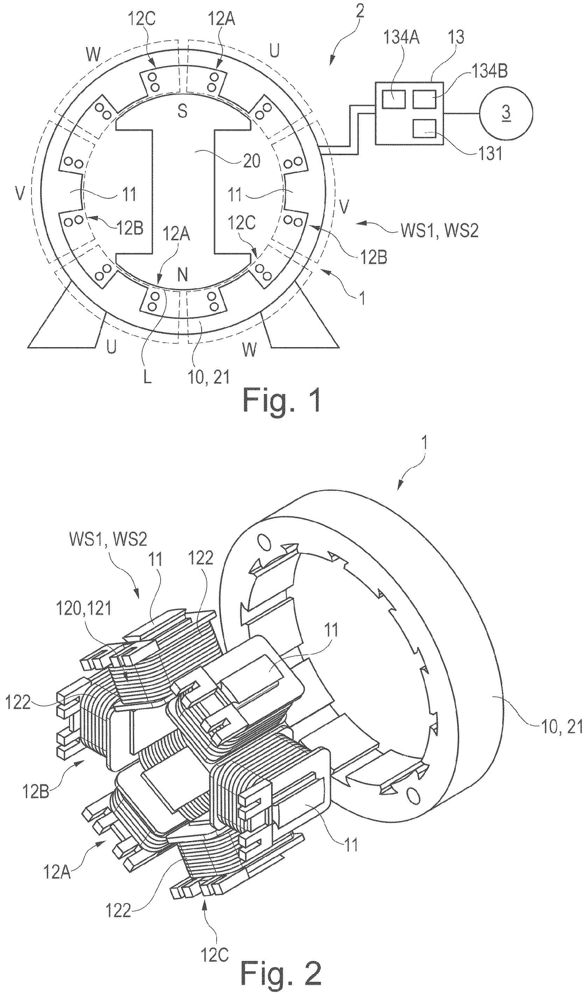

FIG. 1 shows a schematic sectional illustration of a rotating electric machine 2 in the form of a permanently excited synchronous machine. In FIG. 1, the electric machine 2 is in the form of a machine with an internal rotor. The electric machine 2 includes a stator 21 that has an opening, in particular a through-opening in which a rotor 20 is arranged in a rotatably mounted manner.

The stator 21 includes a body 10 in the form of a laminated core, on which teeth are anchored, which are referred to below as stator teeth 11. The stator teeth 11 are aligned with an air gap L between the body 10 of the stator 21 and the rotor 20. The stator teeth 11 protrude radially from the body 10, in the present case radially inward. The stator 21 has a stator winding that includes a plurality of windings 12A-12C (in the form of tooth windings). The stator winding in the present case is designed for three-phase operation, (connected to a three-phase AC voltage having phases U, V, W). During intended operation of the electric machine 2, the AC voltage is accordingly applied to the stator winding.

The rotor 20 is in the form of a salient-pole rotor that includes permanent magnets for providing the magnetic flux. In the present configuration, there is provision for the rotor 20 to have exactly one magnetic north pole N and one magnetic south pole S. In alternative configurations, there may also be provision for more magnetic poles, e.g., in alternation in the circumferential direction transverse to an axis of rotation of the rotor 20 (relative to the stator 21).

The rotor 20 is rotatably mounted. As a result of the three-phase AC voltage, the phases U, V, W thereof each being phase-shifted by 120°, a magnetic rotating field is generated during intended operation, which magnetic rotating field interacts with the permanently excited magnetic field provided by the rotor 20 such that a corresponding rotational movement of the rotor 20 in relation to the stator 21 may be brought about during operation of the motor. In certain examples, the electric machine 2 is used as a drive motor, e.g., for a propeller of an aircraft. The portions of the stator winding assigned to the respective phases U, V, W are schematically illustrated in FIG. 1. One winding 12A-12C is in each case respectively assigned to one of the phases U, V, W.

The stator winding of the electric machine 2 is connected to an inverter system 13 (in this example of a three-phase design). The inverter system 13 provides the electric AC voltage with the three phases U, V, W. The inverter system 13 obtains the electric energy required for the intended operation from an energy source 3 connected to the inverter system 13. In the present configuration, the energy source 3 is a DC voltage source which provides electrical energy from a suitable electrical energy source, for example, a rechargeable battery or the like. Alternatively, or additionally, a fuel cell and/or the like or, in the case of stationary applications, an energy supply from a public energy supply network may be provided, for which purpose a rectifier for converting an alternating current of the public energy supply network into direct current may be provided.

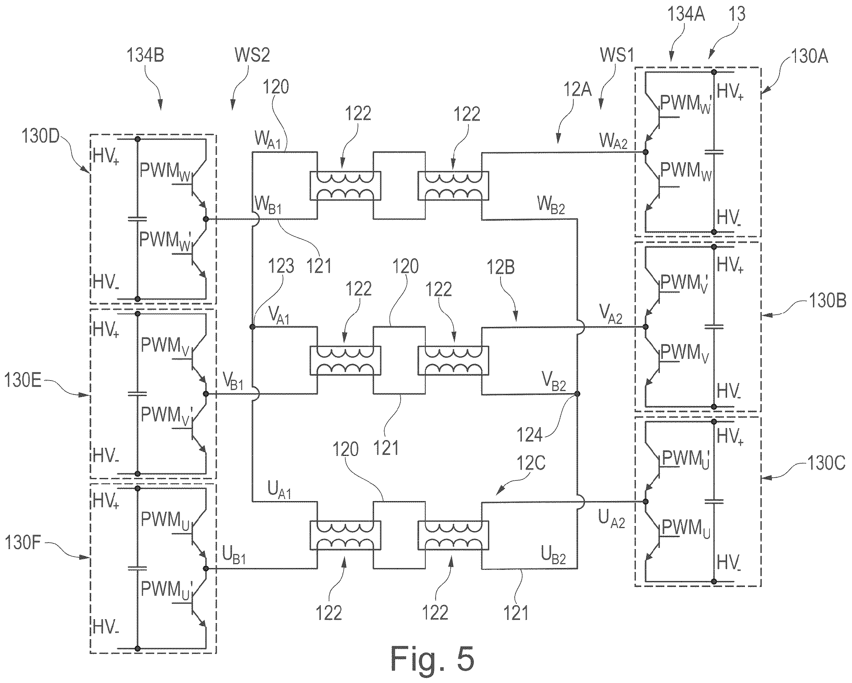

The inverter system 13 has inverter units assigned for providing the phases U, V, W, which inverter units are explained in more detail further below in connection with FIG. 5, for example. In this case, each inverter unit has its own half-bridge circuit. The half-bridge circuits are connected to a DC link circuit, which is not illustrated any further in FIG. 1, of the inverter system 13, in order to thus be supplied with electrical energy. The DC link circuits may have a voltage of 25 V or more, 100 V or more, or in the range of 800 to 3000 V.

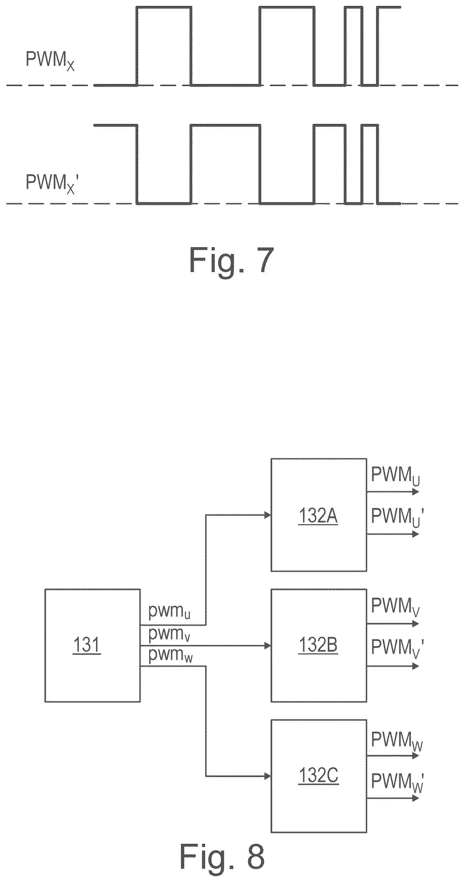

The half-bridge circuit has a series circuit including two electronic switching elements (e.g., transistors) that are connected to the link circuit DC voltage of the inverter system 13. The electronic switching elements are operated in a clock mode, as explained in more detail below in connection with FIG. 7, which provides clock patterns in the manner of a PWM signal, for example. The corresponding phase U, V, W of the three-phase AC voltage is then available at a respective center tap of the half-bridge circuits. Filtering is carried out by the inductance of the windings 12A-12C, with the result that an appropriate AC current is established for each phase U, V, W, which AC current may be virtually sinusoidal if the inverter units are suitably controlled.

The inverter system 13 comprises a first inverter 134A and a second inverter 134B. the first inverter 134A comprises a first set of inverter units, in this example three, i.e., one for each phase U, V, W. The second inverter 134B comprises a second set of inverter units, in this example three, i.e., one for each phase U, V, W. The windings 12A-12C are divided in two winding systems WS1, WS2. Thereof, first winding system WS1 is electrically connected to the first inverter 134A and is not electrically connected to the second inverter 134B. Accordingly, the second winding system WS2 is electrically connected to the second inverter 134B and is not electrically connected to the first inverter 134A. The first inverter 134A can operate the first winding system WS1 independently of the second inverter 134B and second winding system WS2 (and vice versa). If one of the inverters 134A, 134B or one of the winding systems WS1, WS2 fails, the other can still be operated to drive the rotor 20.

For the sake of simplicity, only one energy source 3 is shown. However, more than one energy source can be provided or the energy source 3 may have two or more mutually independent parts. For example, the first inverter 134A is provided with power from a first part of the energy source 3, and the second inverter 134B is provided with power from a second part of the energy source 3.

The inverter system 13 comprises a control unit 131. The control unit 131 controls the inverters 134A, 134B.

For the sake of simplicity, the inverter system 13 is counted here as part of the arrangement and thus as part of the electric machine 2, but may also be described as a separate electrical drive device which drives the electrical machine 2.

FIG. 2 shows a schematic exploded illustration of the stator 21 of the electric machine 2. The stator 21 has the body 10 in which the stator teeth 11 may be joined together with the annular body 10 by a mechanical connection and may thus be fixed thereon, in particular, mechanically fixed thereon. Alternatively, the stator teeth 11 may be formed in one piece with the body 10.

The stator teeth 11 are fitted with respective winding portions 122 of the windings 12A-12C. The stator winding has a plurality of windings 12A-12C, (e.g., exactly three windings). A respective one of the windings 12A-12C may be arranged at least on one of the stator teeth 11. In the present case, each winding 12A-12C extends over a plurality of stator teeth 11, (e.g., specifically two opposite stator teeth). For this purpose, each winding 12A-12C may have at least one winding portion 112 or a plurality of winding portions 122 (e.g., two winding portions). Each winding portion 122 surrounds (e.g., exactly) one stator tooth 11. In this example, each winding portion 122 forms a coil. For example, each winding 12A-12C comprises at least one coil or more than one coil. In the present example, each winding 12A-12C comprises two coils.

Each winding 12A-12C has a respective first electrical conductor 120, which at each winding portion 122 is arranged in a plurality of turns circumferentially around the respective stator tooth 11. Between the winding portions 122, the first electrical conductor 120 includes one or more corresponding connecting portions via which the portions of the first electrical conductor 120 at the winding portions 122 are electrically connected to each other.

Each winding 12A-12C further has a respective second electrical conductor 121 that likewise at each winding portion 122 is arranged in a plurality of turns circumferentially around the respective stator tooth 11. Between the winding portions 122, the second electrical conductor 121 includes one or more corresponding connecting portions via which the portions of the second electrical conductor 121 at the winding portions 122 are electrically connected to each other.

The first electrical conductors 120 and the second electrical conductors 121 each have end portions to which they are connected in a manner described in more detail below. Between the respective end portions (and, in this example, over their entire lengths), the first electrical conductors 120 and the second electrical conductors 121 are electrically insulated from each other. The windings 12A-12C are connected in the electric machine 2 such that the three-phase connection to the inverter system 13 is present.

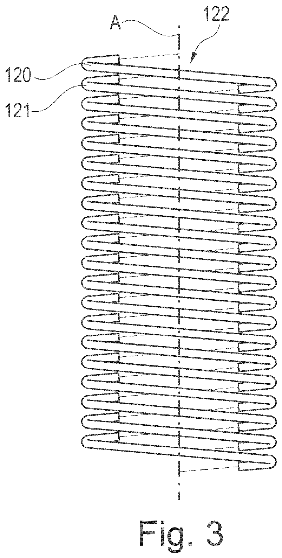

FIG. 3 shows a schematic illustration of a winding portion 122 of one of the windings 12A-12C. The first electrical conductor 120 in this case is wound around the stator tooth 11, which is not illustrated in FIG. 3. The winding on the stator tooth 11 extends here around and along a winding axis A. In the present case, the winding portion 122 is configured in the form of an elongate coil along the winding axis A.

Furthermore, the winding portion 122 of the winding 12A-12C includes the respective second electrical conductor 121 that is electrically insulated from the first electrical conductor 120. The second electrical conductor 121 also has a plurality of turns arranged circumferentially around the same stator tooth 11, so that the winding on the stator tooth 11 extends around and along the winding axis A. The respective turns of the first and second electrical conductors 120, 121 are arranged in a bifilar manner. In other words, one turn of the first electrical conductor 120 is arranged between two adjacent turns of the second electrical conductor 121 (and vice versa) along the winding axis A of the winding portion 122 (with the exception of the outermost two turns). This has the advantage that, in the event of an inter-turn short circuit between two adjacently arranged turns, the inter-turn short circuit occurs between the first electrical conductor 120 and the second electrical conductor 121. An inter-turn short circuit thus does not occur inside a winding of the same electrical conductor. This makes it possible to prevent large induced currents in the case of an inter-turn short circuit and therefore large thermal and electrical stresses.

Optionally, each first electrical conductor 120 and/or each second electrical conductor 121 includes two or more individual conductors insulated from each other.

Notably, the coils formed by the respective winding portions 122 may be elongate (e.g., in a direction parallel to the rotor 20 rotational axis), as shown in FIG. 2. Here, the winding axis A may be defined to be at a position inside the coil, e.g., in the center of the coil. More complicated coil shapes are also possible, such as bent along the longitudinal axis, particular for alternative machine topologies such as a transverse flux machine or the like.

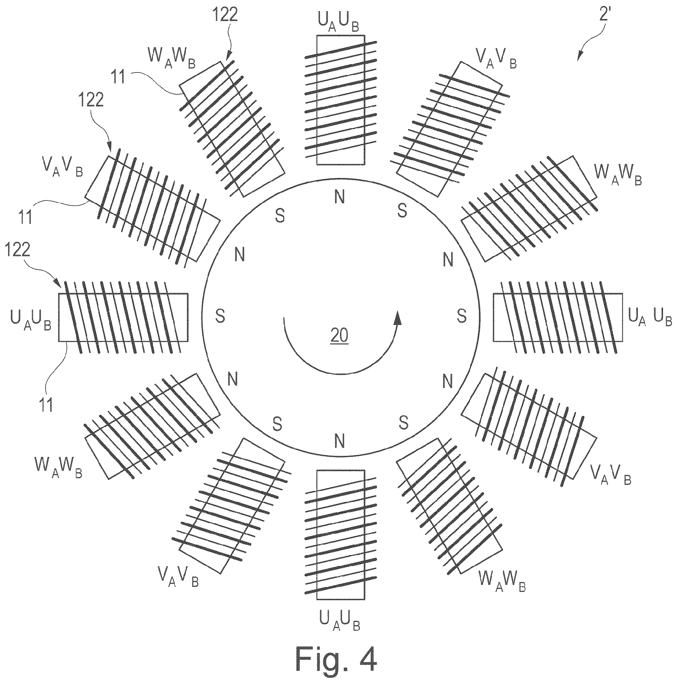

FIG. 4 shows a schematic illustration of an electric machine 2' in the form of a synchronous machine that, in contrast to the electric machine 2 according to FIGS. 1 and 2, now has a twelve-pole rather than a six-pole design. The corresponding stator therefore has twelve stator teeth 11. These are arranged equidistantly in the circumferential direction in the present case. The rotor 20 is again arranged in a through-opening formed by the stator, which rotor likewise has a twelve-pole design in this configuration and therefore provides six north poles N and six south poles S arranged in alternation in the circumferential direction. Here too, the magnetic flux provided by the rotor 20 is provided by permanent magnets arranged, e.g., in the region of the outer circumference of the rotor 20. The numbers of poles are provided by way of example and other numbers are also possible.

Each stator tooth 11 of the stator teeth 11 is also equipped here with a winding portion 122 of one of the three windings 12A-12C. Each winding of the three windings 12A-12C again has a respective first electrical conductor and a respective second electrical conductor (illustrated by different line thicknesses in FIG. 4 purely for the purpose of illustration) that are wound onto the respective stator teeth 11 in a bifilar manner. This electric machine 2' is likewise designed to be supplied with a three-phase AC voltage, wherein each of the phases is again denoted using U, V, W.

Notably, the electric machines 2, 2' described with reference to FIGS. 1-4 are inner-runner radial flux machines. Notably, the principles described herein can also be applied to outer-runner radial flux machines as well as to a transverse flux machine and to an axial flux machine.

FIG. 5 shows an electrical interconnection of the windings 12A-12C and the inverter units 130A-130F of the inverter system 13 of the electric machine 2 according to FIG. 1.

The first electrical conductors 120 (e.g., three first electrical conductors) of the windings 12A-12C form a first winding system WS1 and the second electrical conductors 121 (e.g., three second electrical conductors) of the windings 12A-12C form a second winding system WS2. The first winding system WS1 is connected to three inverter units 130A-130C. These three inverter units 130A-130C form the first three-phase inverter 134A. Each first electrical conductor 120 is connected with an end portion WA2, VA2, UA2 thereof to one of the inverter units 130A-130C. The respective other end portions WA1, VA1, UA1 of the first electrical conductors 120 are electrically connected to each other at a first star point 123.

The second winding system WS2 is connected to further three inverter units 130D-130F. These further three inverter units 130D-130F form the second three-phase inverter 134B. Each second electrical conductor 121 is connected with an end portion WB1, VB1, UB1 to one of the inverter units 130D-130F. The respective other end portions WB2, VB2, UB2 of the second electrical conductors 121 are electrically connected to each other at a second star point 124.

The inverter system 13 thus includes six inverter units 130A-130F, two for each of the three phases U, V, W, and of these two inverter units, one each for the first winding system WS1 and one for the second winding system WS2. As already described, each inverter unit 130A-130D has a half-bridge circuit. An optional capacitor is used as a low-pass filter in each case.

A (e.g., same) DC voltage (designated by HVA+ and HVA-) is applied to the inverter units 130A-130D of both inverters 134A, 134B of the inverter system 13. For example, the DC voltage is 25 V or more, 100 V or more, or in a range of 800 to 3000 V.

Furthermore, all six winding portions 122 for the six stator teeth 11 are shown, wherein each winding of the first and second electrical conductors 120, 121 is illustrated only schematically.

First, the winding 12A for a first phase W will be considered. This winding 12A includes a first electrical conductor 120 and a second electrical conductor 121. Both electrical conductors 120, 121 extend over winding portions 122 on the same (e.g., one or more, in this example two) stator teeth 11 but are insulated from one another. Both electrical conductors 120, 121 have the aforementioned two end portions WA1, WA2, WB1, WB2. Here, both electrical conductors 120, 121 are free of junctions between their end portions WA1, WA2, WB1, WB2. The electrical conductors 120, 121 each establish an electrical connection between the respective two end portions WA1, WA2, WB1, WB2. The winding portions 122 of the winding 12A lie between the end portions WA1, WA2, WB1, WB2 of the electrical conductors 120, 121.

One end portion WA2 of the first electrical conductor 120 is electrically connected to a first inverter unit 130A of the inverter system 13, and the other end portion WA1 of the first electrical conductor 120 is electrically connected to the first star point 123. One end portion WB1 of the second electrical conductor 121 is electrically connected to a fourth inverter unit 130D of the inverter system 13, and the other end portion WB2 of the second electrical conductor 121 is electrically connected to the second star point 124.

The end portions of the first electrical conductor 120 of the winding 12B for a second phase V are denoted using VA1 and VA2. One end portion VA2 of the first electrical conductor 120 is electrically connected to the inverter system 13, specifically, to a second inverter unit 130B thereof, and the other end portion VA1 of the first electrical conductor 120 is electrically connected to the first star point 123.

The end portions of the second electrical conductor 121 of the winding 12B for the second phase V are correspondingly denoted using VB1 and VB2. One end portion VB1 of the second electrical conductor 121 is electrically connected to the inverter system 13, specifically, to a fifth inverter unit 130E thereof, and the other end portion VB2 of the second electrical conductor 121 is electrically connected to the second star point 124.

The end portions of the first electrical conductor 120 of the winding 12C for a third phase U are denoted using UA1 and UA2. One end portion UA2 of the first electrical conductor 120 is electrically connected to the inverter system 13, specifically to a third inverter unit 130C thereof, and the other end portion UA1 of the first electrical conductor 120 is electrically connected to the first star point 123.

The end portions of the second electrical conductor 121 of the winding 12C for the third phase U are correspondingly denoted using UB1 and UB2. One end portion UB1 of the second electrical conductor 121 is electrically connected to the inverter system 13, specifically, to a sixth inverter unit 130F thereof, and the other end portion UB2 of the second electrical conductor 121 is electrically connected to the second star point 124.

As another example, each of the first and second inverters may comprise a full-bridge circuit for each of the phases U, V, W of the respective winding system. Specifically, each of the first and second inverters 134A, 134B may comprise two phase units for each phase U, V, W, wherein an electrical conductor of each of the electrical phases U, V, W is connected between the respective two phase units. Thus, each winding system comprises six phase units. Each of the phase units has two switching elements connected in series and is connected to a DC voltage intermediate circuit of the inverter. The respective phase U, V, W of the multiphase electrical AC voltage may be provided at a center tap between the switching elements. Such a circuit arrangement has no star point and allows precise control.

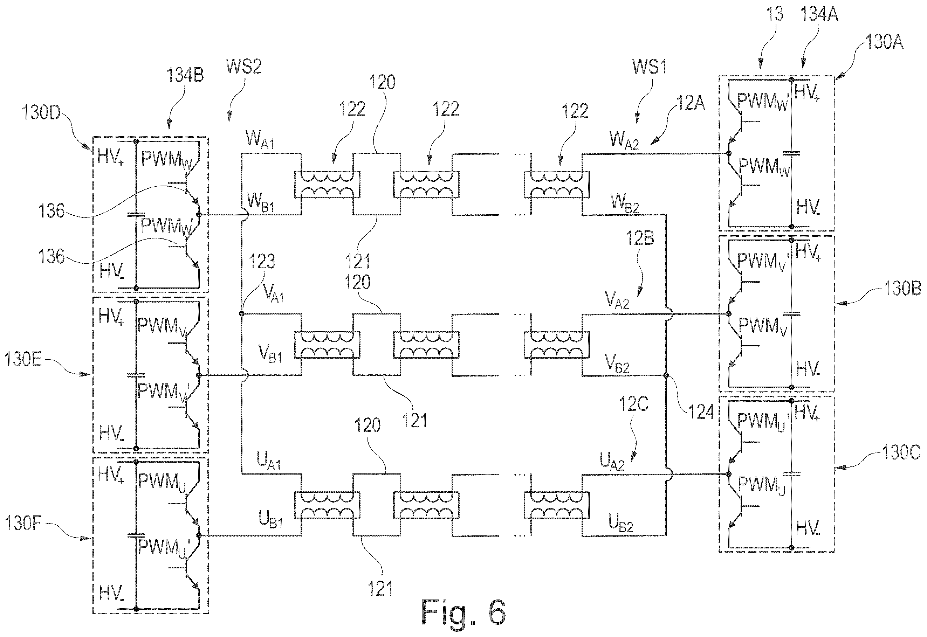

FIG. 6 shows substantially the same circuitry as FIG. 5, wherein more winding portions 122 are illustrated. It can be seen that the windings 12A-12C may have a smaller or larger number of winding portions 122 depending on the application, e.g., in total six (cf. in particular FIGS. 2 and 5), twelve (cf. in particular FIG. 4), or 18, to name just some examples.

While the windings 12A-12C are arranged between the inverter units 130A-130F according to FIGS. 5 and 6, this arrangement is only exemplary.

Furthermore, it may be seen that in FIGS. 5 and 6 the end portions, connected to the inverter units 130A-130F, of the first and second conductors 120, 121 of each individual one of the windings 12A-12C face away from one another with respect to the common winding portions 122.

To create the alternating three-phase voltage, a current introduced into the electrical conductors 120, 121 are controlled by switching the transistors (or other types of switches 136) of the inverter units 130A-130F. The transistors are controlled by signals, in the present case by pulse width modulated signals, which may also be referred to as PWM signals for short (pulse width modulation). The PWM signals alternate between two discrete values, e.g., "on" and "off", which open and close the corresponding transistor (or other type of switch), respectively.

FIG. 7 shows an example of such PWM signals, wherein X stands for the respective phase U, V, W. The PWM signals for the individual phases U, V, W are, e.g., the same, only shifted in time.

Furthermore, an inverted PWMX' signal is provided for each PWMX signal, which assumes the corresponding opposite discrete value in relation to the PWMX signal over time. The RWMX' signal corresponds to the inverted PWMX signal.

As illustrated, e.g., with reference to FIGS. 5 and 6, for each winding 12A-12C, the reverse PWM signal PWMW', PWMV', PWMU' is applied to the respective transistor of the inverter unit 130A, 130B, 130C of the first electrical conductor 120 connected to the positive pole HV+ of the DC voltage. By contrast, the PWM signal PWMW, PWMV, PWMU is applied to the transistor of the inverter unit 130A, 130B, 130C of the first electrical conductor 120 connected to the negative pole HV- of the DC voltage.

In the second electrical conductors 121, the PWM signals are applied in reverse. The PWM signal PWMW, PWMV, PWMU is applied to the transistor of the inverter unit 130D, 130E, 130F of the second electrical conductor 121 connected to the positive pole HV+ of the DC voltage. By contrast, the reverse PWM signal PWMW', PWMV', PWMU' is applied to the transistor of the inverter unit 130D, 130E, 130F of the second electrical conductor 121 connected to the negative pole HV- of the DC voltage.

It may therefore be seen that the same PWM signals are applied to the inverter units 130A-130C of the first electrical conductor 120 as to the inverter units 130D-130F of the second electrical conductor 121.

FIG. 8 illustrates a possible generation of the PWM signals PWMX and the reverse PWM signals PWMX'. The control unit 131 of the inverter system 13 generates signals for the three phases U, V, W, which are designated here as pwmu, pwmv, pwmw. These are each provided to a power electronics driver 132A-132C, which generate the respective PWM signals and reverse PWM signals for the corresponding phase U, V, W based on them. The power electronics drivers 132A-132C are connected (e.g., electrically) to the inverter units 130A-130F of the respective phase U, V, W.

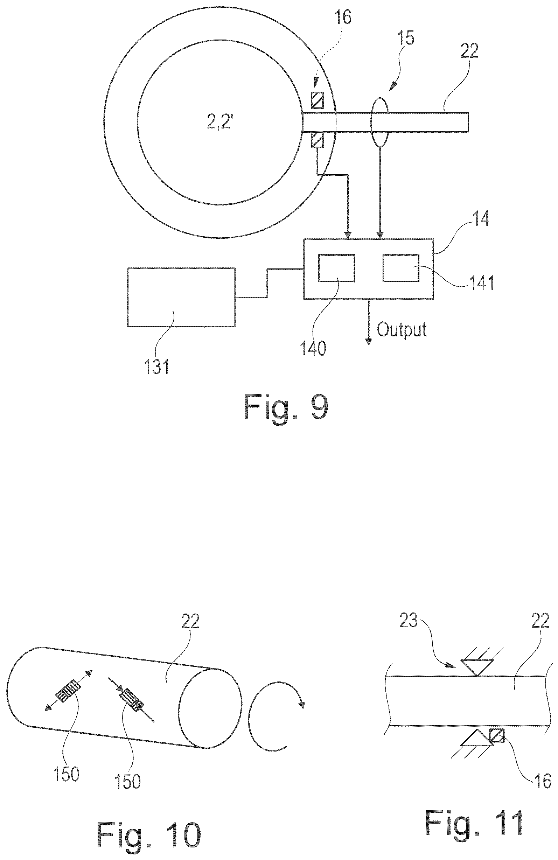

FIG. 9 shows the electric machine 2, while the same description also holds for the electric machine 2'.

As already described above, the electric machine comprises the stator 21 having the first winding system WS1 and the second winding system WS2, wherein at least one (first) electrical conductor 120 of the first winding system WS1 and at least one (second) electrical conductor 121 of the second winding system WS2 are at least partially wound around a common winding axis A and alternate in a direction of the winding axis A. The at least one (first) electrical conductor 120 of the first winding system WS1 and at least one (second) electrical conductor 121 of the second winding system WS2 are at least partially disposed in a bifilar arrangement. The electric machine 2, 2' is a bifilar machine. As described above, the rotor 20 is rotatably mounted with respect to the stator 21.

According to FIG. 9, the electric machine 2, 2' further comprises a monitoring device 14. The monitoring device is configured to receive torque signals indicative of a torque transmitted by the rotor 20 at various points in time and (alternatively: or) to receive vibration signals indicative of a vibration of the rotor 20 at various points in time. The monitoring device 14 is further configured to perform a comparison based on the torque signal and/or the vibration signal and based on at least one predetermined or configurable or adjustable threshold.

The monitoring device 14 is also configured to detect a short circuit between the first electrical conductor 120 and the second electrical conductor 121 based on the comparison.

In the present example, the monitoring device 14 comprises a processor 140 and a memory 141 storing instructions thereon which, when executed by the processor 140, causes the monitoring device 14 to perform the steps outlined above.

In order to measure the torque, the electric machine 2, 2' comprises a torque sensor 15 for measuring the torque resulting from operation of the electric machine 2, 2'. The torque sensor 15 is communicatively coupled with the monitoring device 14. The torque sensor 15 provides the torque signals indicative for the measured torque to the monitoring device 14. The torque sensor 15 measures the torque on a shaft 22 of the electric machine 2, 2'. The shaft 22 transmits the torque provided by the rotor 20 to a propeller or the like. The shaft 22 is only shown simplified in FIG. 9.

As shown in FIG. 10, the torque sensor 15 may comprise one or more strain gauges 150 to measure the torque. The strain gauge(s) 150 may be diagonally fixed on the shaft 22 (or on a part of the rotor 20) so as to be stretched or compressed by bending of the shaft 22 or other component, as illustrated by arrows in FIG. 10.

The strain gauges 150 may be wirelessly coupled with a receiver of the torque sensor 15 via induction.

Further, the electric machine 2, 2' comprises one or more vibration sensors 16 for measuring vibrations resulting from operation of the electric machine 2, 2' and for providing the vibration signals indicative for the measured vibrations to the monitoring device 14.

As shown in FIG. 11, the vibration sensor 16 in this example is mounted on the stator 21 or on a static part fixedly connected to the stator 21 and close to or on a bearing 23 (e.g., roller bearing or journal bearing) supporting rotation of the rotor 20 or a rotating part driven by the rotor 20.

The control unit 131 is configured to operate the stator 21 so as to drive the rotor 20 with a target torque value. For this, the control unit 131 provides according PWM signals as described above. The monitoring device 14 is configured to receive this target torque value from the control unit 131 and to perform the comparison by calculating a respective difference or a respective ratio between the torque indicated by the torque signals and the target torque value and comparing the difference or ratio with the at least one threshold.

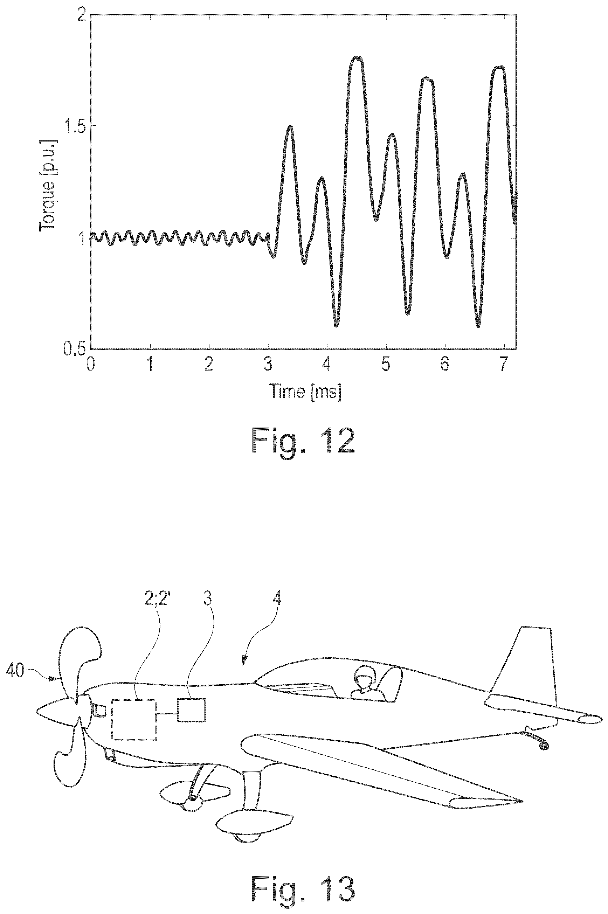

FIG. 12 shows the ratio of the torque indicated by the measured torque signals and the target torque versus time. Notably, even under healthy operating conditions, a certain level of torque ripple and vibration will be present, depending on the design and operating condition. However, during a fault condition, the magnitude of these torque and vibration signals significantly increase as a characteristic of the bifilar configuration, indicating a fault occurrence. As can be seen in FIG. 12, first, the fluctuations of the normalized torque are small. At 3 ms, a short circuit between neighboring turns of one of the bifilar coils occurs. As a result, the fluctuations increase (by more than an order of magnitude). As a result of this torque fluctuations, the electric machine 2, 2' starts to vibrate which can be detected by the vibration sensors 16. In a healthy machine, the difference between the measured and desired target torque signals is typically small and within an expected range, accounting for the torque harmonics and sensor accuracy. However, during a turn-to-turn fault condition, this difference will significantly exceed the expected range. By monitoring this difference (even based on an unfiltered threshold comparison), the system can quickly and efficiently detect faults.

In order to detect the torque signature shown in FIG. 12, the monitoring device 14 is configured to perform one or more analyses, each with the normalized torque or directly with the measured torque.

For one possible analysis, the monitoring device 14 may be configured to perform the comparison by determining the time derivative of the torque signals and comparing the time derivative with the at least one threshold. In this case, the corresponding threshold is a maximum gradient. Gradients below the threshold are regarded as within the normal operation of the machine, gradients above are regarded as indicating a fault.

For another possible analysis, the monitoring device 14 is configured to perform the comparison by directly comparing the torque signals or normalized (by division with the target torque) torque signals with the at least one threshold. In this case, the corresponding threshold is a maximum torque value. Here, torque values below the threshold are regarded as within the normal operation of the machine, torque values above are regarded as indicating a fault.

For another possible analysis, the monitoring device 14 is configured to perform the comparison by bandpass-filtering the torque signal, determining a spectral energy contained in the bandpass-filtered torque signal and comparing the determined spectral energy with the at least one threshold.

When the at least one threshold is exceeded, the monitoring device 14 determines that a short circuit between the first electrical conductor 120 and the second electrical conductor 121 has occurred.

Alternatively or in addition to the torque measurement, the monitoring device 14 may perform the vibration measurement, since the torque ripple and the unbalanced magnetic pull resulting from the asymmetry of the faulty bifilar phase systems, i.e., unbalanced normal forces between rotor 20 and stator 21, generate pronounced vibrations. Threshold detection and bandpass filtering as described above for torque signals can also be applied to the vibration signals. Notably, the same vibration sensors 16 can also be used for the detection of bearing faults. The monitoring unit 14 may additionally be configured to detect such bearing faults, e.g., by measuring an increased vibration without detecting increased torque ripples.

The harmonic spectrum of these measurements can undergo notable changes during a fault. Therefore, the monitoring device 14 may be configured to analyze the harmonic components and, based on this analysis, detect a fault, and/or to perform a spectral analysis detecting the fault by occurrence of predefined frequencies (above a respective given threshold).

In response to detecting the short circuit, the monitoring device 14 is configured to initiate countermeasures, e.g., by triggering a change of operation of the electric machine 2, 2'. For example, the monitoring device 14 triggers a shutdown of the electric machine 2, 2'. The described fault detection mechanism allows a robust and sensitive detection.

The monitoring unit 14 may be a digital signal processor, a microcontroller or FPGA, where the difference between the measured and desired (reference) torque signals can be calculated using a simple program. This approach eliminates the need for harmonic signal extraction or other resource-intensive signal processing techniques.

Alternatively, the monitoring device 14 may be an analogue signal processor. Analog subtraction between the measured signal and the desired target torque signal from a controller can be achieved using an analog device like a differential amplifier if, e.g., an analogue output signal of the controller is provided. This device calculates the difference between two input signals and outputs a voltage that is proportional to this difference. A decision can be made using a threshold value for the difference.

For example, the first input to the device is the desired torque reference. This signal is provided in digital form either from a Digital Signal Processor or similar device used as controller. It may be converted to an analog signal using a Digital-to-Analog Converter to represent the desired torque in electrical form. The second input may be the measured torque. This is obtained from a torque transducer, e.g., based on strain gauges 150 as described, which converts the physical torque into an electrical signal. The analog device (e.g. a differential amplifier) receives these two input voltages. It then calculates the difference between them. The output is a voltage that represents the difference between the desired and measured torque signals. At healthy condition, the output voltage will be within a predetermined limit. A deviation from this limit is detected as the monitoring device 14 as a fault condition.

It is further worth noting that in the control unit 131, torque may not be a direct control variable. Conventionally, phase current values are controlled and characteristic properties (inductances and linked flux) of a look-up table are used to compute a torque value for the control algorithm from the phase current measurements. In the case of a fault, the characteristic properties of the machine, here the bifilar winding sets, change and as a result the calculated values for the control are erroneous. Hence, there may be two factors changing the torque gradient in case of a fault: The physical effect of the fault due to the instantaneous change in the magnetic field due to the fault; and the (erroneous) fault reaction of the controller. The result can be a torque rise as a direct effect of the first effect and a subsequent effect due to the (erroneous) current control. Also, there may be some level of delay between these effects.

To improve the quality of the detection, the monitoring device may calculate one, two or all three of: exceedance of a maximum torque threshold, gradient excursion and maximum spectral energy level exceedance.

Optionally, the control unit 131 is configured for normal operation such that the torque gradient does not (by fast control) exceed the threshold for detection of the fault.

Since the voltage is, for example, supplied from opposite ends of the bifilar windings, a known potential difference (with the peak equal to the DC link) will be seen between the star points of the respective systems during healthy operation. If a fault arises, this potential difference will change. Thus, the star point to star point potential difference can be monitored for an effective fault detection. Alternatively, the star point-to-ground voltage of the two systems can be measured and compared (the ground may be defined as a potential between two (e.g., equal) voltage supplies forming the DC link). Under healthy conditions, these two voltages should be equal in magnitude but opposite in polarity. A fault condition can alter this relationship. For enhancing sensitivity and integrity, different harmonic frequency components can be selected and utilized based on the operating conditions.

Additionally or alternatively, a change of electrical currents and/or voltages in the winding systems WS1, WS2 may be monitored to detect a fault or to enhance the significance of the measurement.

Additionally or alternatively, the star point potentials of the two bifilar systems can be compared individually against an artificial star point, e.g., formed by a (e.g., low signal) external circuit. Similar deviations occurring in both comparison between the machine star point and the artificial star point will indicate a turn-to-turn fault. Deviations in the comparison of only one of the machine star points to one of the artificial star points may indicate other faults than turn-to-turn in an early stage before inductive coupling effects become notable. As an example the artificial star points may be formed by a three-phase winding operated by a three-phase AC, e.g., synchronized with the AC of the electric machine 2, 2'.

FIG. 13 shows an aircraft 4 in the form of an electrically driven airplane. The aircraft 4 includes a propeller 40 which is driven by the above-described electric machine 2 according to FIG. 2 (alternatively by the electric machine 2' according to FIG. 4).

The aircraft 4 furthermore includes an energy source 3 in the form of an electric battery. The electric machine 2 is supplied with energy by the energy source 3, wherein the energy source 3 is electrically connected to the inverter system 13.

The disclosure is not limited to the embodiments described above, and various modifications and improvements may be made without departing from the concepts described here. Any of the features may be used separately or in combination with any other features, unless they are mutually exclusive, and the disclosure extends to and includes all combinations and sub-combinations of one or more features that are described herein.

It is to be understood that the elements and features recited in the appended claims may be combined in different ways to produce new claims that likewise fall within the scope of the present disclosure. Thus, whereas the dependent claims appended below depend on only a single independent or dependent claim, it is to be understood that these dependent claims may, alternatively, be made to depend in the alternative from any preceding or following claim, whether independent or dependent, and that such new combinations are to be understood as forming a part of the present specification.

While the present disclosure has been described above by reference to various embodiments, it may be understood that many changes and modifications may be made to the described embodiments. It is therefore intended that the foregoing description be regarded as illustrative rather than limiting, and that it be understood that all equivalents and/or combinations of embodiments are intended to be included in this description.

### LIST OF REFERENCE SIGNS

- 10: body
- 11: stator tooth
- 12A-12C: winding
- 120: first electrical conductor
- 121: second electrical conductor
- 122: winding portion
- 123: first star point
- 124: second star point
- 13: inverter system
- 130A-130F: inverter unit
- 131: control unit
- 132A-132C: power electronics driver
- 134A, 134B: inverter
- 136: switch
- 14: monitoring device
- 140: processor
- 141: memory
- 15: torque sensor
- 150: strain gauge
- 16: vibration sensor
- 2, 2': electric machine
- 20: rotor
- 21: stator
- 22: shaft
- 23: bearing
- 3: energy source
- 4: aircraft
- 40: propeller
- A: winding axis
- L: air gap
- N: north pole
- S: south pole
- U, V, W: phase
- WS1, WS2: winding system

## Claims

1. An electric machine (2, 2'), comprising:
- a stator (21) having a first winding system (WS1) and a second winding system (WS2), wherein at least one electrical conductor (120) of the first winding system (WS1) and at least one electrical conductor (121) of the second winding system (WS2) are at least partially wound around a common winding axis (A) and alternate in a direction of the winding axis (A);
- a rotor (20) rotatably mounted with respect to the stator (21); and
- a monitoring device (14) configured to:
∘ receive torque signals indicative of a torque transmitted by the rotor (20) at various points in time and/or to receive vibration signals indicative of a vibration of the rotor (20) at various points in time and/or of a vibration of the stator (21) at various points in time;
∘ perform a comparison based on the torque signal and/or the vibration signal and based on at least one threshold; and
∘ detect a short circuit between the at least one electrical conductor (120) of the first winding system (WS1) and the at least one electrical conductor (121) of the second winding system (WS2) based on the comparison.

2. The electric machine (2, 2') of claim 1, further comprising a torque sensor (15) for measuring a torque resulting from operation of the electric machine (2, 2') and for providing the torque signals indicative for the measured torque to the monitoring device (14).

3. The electric machine (2, 2') of claim 2, wherein the torque sensor (15) comprises at least one strain gauge (150) mounted on the rotor (20) or on a shaft (22) driven by the rotor (20).

4. The electric machine (2, 2') of any of the preceding claims, further comprising a vibration sensor (16) for measuring a vibration resulting from operation of the electric machine (2, 2') and for providing the vibration signals indicative for the measured vibration to the monitoring device (14).

5. The electric machine (2, 2') of any of the preceding claims, wherein the vibration sensor (16) is mounted on the stator (21) or on a static part fixedly connected to the stator (21) and adjacent to a bearing supporting rotation of the rotor (20) or a rotating part driven by the rotor (20).

6. The electric machine (2, 2') of any of the preceding claims, further comprising a control unit (131) configured to operate the stator (21) so as to drive the rotor (20) with a target torque value, wherein the monitoring device (14) is configured to receive the target torque value from the control unit (131).

7. The electric machine (2, 2') of claim 6, wherein the monitoring device (14) is configured to perform the comparison by calculating a respective difference or a respective ratio between the torque indicated by the torque signals and the target torque value and comparing the difference or ratio with the at least one threshold.

8. The electric machine (2, 2') of any of the preceding claims, wherein the monitoring device (14) is configured to perform the comparison by determining the time derivative of the torque or vibration signals and comparing the time derivative with the at least one threshold.

9. The electric machine (2, 2') of any of the preceding claims, wherein the monitoring device (14) is configured to perform the comparison by comparing the torque or vibration signals with the at least one threshold.

10. The electric machine (2, 2') of any of the preceding claims, wherein the monitoring device (14) is configured to perform the comparison by bandpass-filtering the torque signal, determining a spectral energy contained in the bandpass-filtered torque signal and comparing the determined spectral energy with the at least one threshold.

11. The electric machine (2, 2') of any of the preceding claims, wherein the monitoring device (14) is configured to detect a short circuit between the first electrical conductor (120) and the second electrical conductor (121) based on the comparison by determining that the at least one threshold is exceeded.

12. The electric machine (2, 2') of any of the preceding claims, wherein the monitoring device (14) is configured to detect a short circuit between the first electrical conductor (120) and the second electrical conductor (121) based on the comparison by determining that the comparison based on the torque signal exceeds a torque threshold and/or the comparison based on the vibration signal exceeds a vibration threshold.

13. The electric machine (2, 2') of any of the preceding claims, wherein the monitoring device (14) is configured to trigger a change of operation of the electric machine (2, 2') in response to detecting the short circuit.

14. The electric machine (2, 2') of any of the preceding claims, further comprising an inverter system (13) with a first inverter (134A) for the first winding system (WS1) and a second inverter (134B) for the second winding system (WS2), in particular wherein the first winding system (WS1) comprises three electrical conductors (120) connected with each other at a first star point (123) and the second winding system (WS2) comprises three electrical conductors (121) connected with each other at a second star point (124), wherein the first inverter (134A) provides a respective phase (U, V, W) to each of the three electrical conductors (120) of the first winding system (WS1) and the second inverter (134B) provides a respective phase (U, V, W) to each of the three electrical conductors (121) of the second winding system (WS2).

15. An aircraft (4) comprising the electric machine (2, 2') of any of the preceding claims.
